# EUROPÄISCHE PATENTANMELDUNG

(11) **EP 3 671 241 A1**
(43) Veröffentlichungstag der Anmeldung: **24.06.2020**
(21) Anmeldenummer: 19216482.0
(22) Anmeldetag: 16.12.2019
(51) Int. Cl.: G01R 31/364, G01R 1/20, H01C 1/014, H01C 7/06

(54) **WIDERSTANDSBAUGRUPPE FÜR EINEN BATTERIESENSOR UND BATTERIESENSOR**

(30) Priorität: 20.12.2018 DE 202018005888 U
(71) Anmelder: Continental Automotive GmbH, 30165 Hannover (DE)
(72) Erfinder: Frenzel, Henryk, 60488 Frankfurt am Main (DE); Schramme, Martin, 60488 Frankfurt am Main (DE)

(57) **Zusammenfassung**

Die Erfindung betrifft eine Widerstandsbaugruppe (20) für einen Batteriesensor (10) in einem Fahrzeug, mit einem ersten Anschlusselement (26), einem zweiten Anschlusselement (28) sowie einem Messwiderstand (24) mit einem definierten elektrischen Widerstand, wobei der Messwiderstand (24) zwischen dem ersten Anschlusselement (26) und dem zweiten Anschlusselement (28) angeordnet und elektrisch leitend mit diesen verbunden ist, und wobei der Messwiderstand (24) einen niedrigen Widerstands-Temperaturkoeffizient aufweist, dadurch gekennzeichnet, dass das erste Anschlusselement (26) und/oder das zweite Anschlusselement (28) jeweils zumindest in einem an den Messwiderstand (24) angrenzenden Anschlussbereich aus einem Material mit einem geringeren Widerstands-Temperaturkoeffizient als Kupfer, insbesondere eine Kupferlegierung, besteht.

Die Erfindung betrifft des Weiteren einen Batteriesensor (10) mit einer solchen Widerstandsbaugruppe (20).

## Beschreibung

Die Erfindung betrifft eine Widerstandsbaugruppe für einen Batteriesensor in einem Fahrzeug, mit einem ersten Anschlusselement, einem zweiten Anschlusselement sowie einem Messwiderstand mit einem definierten elektrischen Widerstand, wobei der Messwiderstand zwischen dem ersten und dem zweiten Anschlusselement angeordnet und elektrisch leitend mit diesen verbunden ist. Die Erfindung betrifft des Weiteren einen Batteriesensor mit einer solchen Widerstandsbaugruppe.

In vielen Anwendungen, insbesondere im Fahrzeugbereich, ist es erforderlich, die auftretenden Ströme sehr exakt zu ermitteln bzw. zu messen. Aus dem Stand der Technik sind beispielsweise Verfahren sowie Sensoren bekannt, bei welchen die Stromstärke über den Spannungsabfall über einen im Strompfad angeordneten Messwiderstand ermittelt wird. Der elektrische Widerstand des Messwiderstandes ist sehr genau bekannt. Aus dem erfassten Spannungsabfall sowie dem bekannten elektrischen Widerstand kann über das ohmsche Gesetz der über den Messwiderstand fließende Strom, also der Batteriestrom berechnet werden.

Vorzugsweise werden für den Messwiderstand spezielle Legierungen verwendet, beispielsweise eine Kupfer-Nickel-Mangan-Legierung, die einen geringeren Widerstands-Temperaturkoeffizienten, also eine geringe Änderung des elektrischen Widerstands bei Temperaturänderungen, aufweisen, so dass der elektrische Widerstand bei allen Temperaturen sehr nah am Sollwert liegt.

Die Kontakte zur Erfassung des Spannungsabfalls sind üblicherweise auf den Anschlusselementen angeordnet, so dass sich die Messstrecke über den Messwiderstand sowie abschnittsweise über die Anschlusselemente erstreckt.

Die Anschlusselemente bestehen üblicherweise aus weitgehend reinem Kupfer mit geringen elektrischen Widerstand und sind mit dem Messwiderstand verschweißt. Weitgehend reines Kupfer hat aber eine höhere Temperaturabhängigkeit des elektrischen Widerstandes, also einen hohen Widerstands-Temperaturkoeffizient. Das Verhalten des elektrischen Widerstandes bei verschiedenen Temperaturen ist bekannt, sodass bei bekannter Temperatur der genaue elektrische Widerstand bestimmt werden kann. Zur Bestimmung der Temperatur ist zusätzlich eine Temperaturbestimmung des Batteriesensors erforderlich.

Das weitgehend reine Kupfer unterscheidet sich außerdem in den thermoelektrischen Eigenschaften vom Material des Messwiderstands. Aufgrund der unterschiedlichen thermoelektrischen Eigenschaften des Messwiderstandes und der Anschlusselemente kann es darüber hinaus am Übergang zwischen den Anschlusselementen und dem Messwiderstand zu Thermospannungen kommen, die zu einer Verfälschung der Messergebnisse führen können.

Aufgabe der Erfindung ist es, eine Widerstandsbaugruppe für einen Batteriesensor in einem Fahrzeug bereitzustellen, der eine genauere Messung des Batteriestroms ermöglicht. Aufgabe der Erfindung ist es des Weiteren einen Batteriesensor mit einer solchen Widerstandsbaugruppe bereitzustellen.

Zur Lösung der Aufgabe ist eine Widerstandsbaugruppe für einen Batteriesensor in einem Fahrzeug vorgesehen, mit einem ersten Anschlusselement, einem zweiten Anschlusselement sowie einem Messwiderstand mit einem definierten elektrischen Widerstand, wobei der Messwiderstand zwischen dem ersten und dem zweiten Anschlusselement angeordnet und elektrisch leitend mit diesen verbunden ist, und wobei der Messwiderstand einen niedrigen Widerstands-Temperaturkoeffizient aufweist, dadurch gekennzeichnet, dass das erste Anschlusselement und/oder das zweite Anschlusselement jeweils zumindest in einem an das Widerstandselement angrenzenden Anschlussbereich aus einem Material mit einem geringeren Widerstands-Temperaturkoeffizient als Kupfer, insbesondere eine Kupferlegierung, besteht. Insbesondere wird ein Material gewählt, das ähnliche thermoelektrische Eigenschaften aufweist wie das Material des Messwiderstandes, sodass die Entstehung von Thermospannungen reduziert oder vermieden werden kann.

Vorzugsweise wird ein Material verwendet, das einen Widerstands-Temperaturkoeffizienten von weniger als 3200 ppm/k, insbesondere von weniger als 2000ppm/K, aufweist. Die üblicherweise verwendeten Kupferlegierungen weisen einen Widerstands-Temperaturkoeffizienten von ca. 4000 ppm/K auf, sodass mit einem solchen Material eine deutliche Reduzierung der Temperaturabhängigkeit des elektrischen Widerstandes der Anschlusselemente und somit des elektrischen Gesamtwiderstandes der Messstrecke erzielt werden kann.

Das erste Anschlusselement und/oder das zweite Anschlusselement bestehen vorzugsweise zumindest im Anschlussbereich aus einer Kupfer-Eisen-Phosphor-Legierung, die einen niedrigen Widerstands-Temperaturkoeffizienten sowie ähnliche thermoelektrische Eigenschaften wie das Material des Messwiderstandes aufweist. Des Weiteren weisen Kupfer-Eisen-Phosphor-Legierungen eine im Vergleich zu den bisher verwendeten Kupferlegierungen erhöhte mechanische Stabilität auf, sodass zusätzlich die Stabilität der Widerstandsbaugruppe gegen mechanische Belastungen verbessert werden kann.

Der Messwiderstand besteht beispielsweise aus einer Kupfer-Mangan-Nickel-Legierung, die einen sehr niedrigen Widerstands-Temperaturkoeffizienten sowie ähnliche thermoelektrische Eigenschaften wie eine Kupfer-Eisen-Phosphor-Legierungen aufweist.

Die Dicke sowie der stromdurchflossene Querschnitt des ersten Anschlusselements und des zweiten Anschlusselements kann beliebig gewählt werden, um einen idealen Stromfluss zu gewährleisten. Das erste Anschlusselement und/oder das zweite Anschlusselement können zumindest im Anschlussbereich die gleiche Dicke aufweisen wie der Messwiderstand, sodass eine einfache Kontaktierung mit dem Messwiderstand möglich ist. Beispielsweise beträgt die Dicke zwischen 1,5 und 3,5 mm, vorzugsweise zwischen 1,8 und 3 mm. Die Anschlusselemente können auch unterschiedliche Dicken und unterschiedliche Querschnittsgrößen bzw. Querschnittsformen aufweisen.

Zur Kontaktierung einer Messeinrichtung sind vorzugsweise jeweils am ersten Anschlusselement und am zweiten Anschlusselement zumindest eine Kontaktstelle vorgesehen. Die Kontaktstellen lassen sich an den Anschlusselementen aus einer Kupferlegierung wesentlich einfacher kontaktieren oder herstellen, sodass die Herstellung der Widerstandsbaugruppe vereinfacht ist. Beispielsweise sind die Kontaktstellen als Kontaktpins oder Kontaktstifte ausgebildet, die einstückig mit dem jeweiligen Anschlusselement ausgebildet sind, mit diesen verschweißt oder verlötet sind oder in dieses eingepresst sind.

Zur Lösung der Aufgabe ist des Weiteren ein Batteriesensor für ein Fahrzeug vorgesehen, mit einer Batteriepolklemme zum Anschließen des Batteriesensors an einer Fahrzeugbatterie, einem Stromanschluss und einer vorstehend beschriebenen Widerstandsbaugruppe. Die Widerstandsbaugruppe verbindet die Batteriepolklemme und den Stromanschluss elektrisch leitend miteinander. Des Weiteren ist eine Messeinrichtung zur Erfassung des über die Widerstandsbaugruppe, insbesondere das Widerstandselement fließenden Stroms vorgesehen.

Die Batteriepolklemme kann auch aus den ersten Anschlusselement ausgebildet sein. Der Stromanschluss kann aus dem zweiten Anschlusselement ausgebildet sein.

Beispielsweise wird zur Erstellung der Widerstandsbaugruppe ein flächiges Material bereitgestellt, beispielsweise aus der vorstehend beschriebenen Kupfer-Eisen-Phosphor-Legierung, in das ein Streifen des Materials des Messwiderstandes eingebracht ist. Beispielsweise sind zwei längliche Materialstreifen der Kupfer-Eisen-Phosphor-Legierung an den Längskanten mit den Längskanten eines Materials für den Messwiderstand verbunden, beispielsweise verschweißt.

Die Widerstandsbaugruppe kann aus diesem Material herausgearbeitet werden, beispielsweise ausgestanzt werden. Beispielsweise kann aus dem Material auch ein Rohling ausgestanzt werden, bei dem aus der Kupfer-Eisen-Phosphor-Legierung jeweils eine Grundform für eine Batteriepolklemme sowie den Stromanschluss ausgestanzt wird. Anschließend können die Batteriepolklemme sowie der Stromanschluss durch Umformprozesse, beispielsweise durch eine Stanz-Biege -Prozess, ausgeformt werden.

Vorzugsweise ist die Messeinrichtung jeweils mit einer Kontaktstelle am ersten Anschlusselement und am zweiten Anschlusselement elektrisch leitend verbunden.

Die Messeinrichtung ist beispielsweise eine Spannungserfassungseinrichtung zur Erfassung eines Spannungsabfalls über den Messwiderstand, so dass mit dem erfassten Spannungsabfall sowie dem bekannten elektrischen Widerstand eine Bestimmung des über den Batteriesensor fließenden Batteriestroms erfolgen kann.

Weitere Vorteile und Merkmale ergeben sich aus der nachfolgenden Beschreibung in Verbindung mit den beigefügten Zeichnungen. In diesem zeigen:
- Figur 1: eine perspektivische Darstellung eines Batteriesensors;
- Figur 2: eine schematische Teildarstellung des Batteriesensors aus Figur 1;
- Figur 3: eine Detailansicht der Widerstandsbaugruppe des Batteriesensors aus Figur 1 ;
- Figur4: einen ersten Verfahrensschritt zur Herstellung einer erfindungsgemäßen Widerstandsbaugruppe; und
- Figur 5: einen zweiten Verfahrensschritt zur Herstellung einer erfindungsgemäßen Widerstandsbaugruppe.

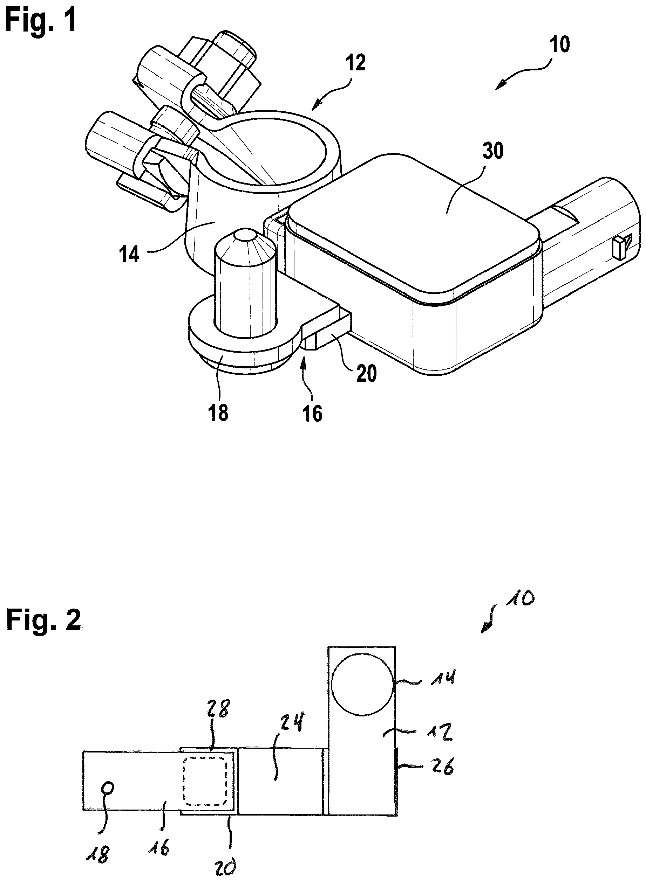

In Figur 1 ist ein Batteriesensor 10 gezeigt, mit einer ersten Anschlussvorrichtung 12, die eine Batteriepolklemme 14 aufweist, einer zweiten Anschlussvorrichtung 16, die einen Kabelanschluss 18 für ein Massekabel aufweist, sowie mit einem Widerstandsbaugruppe 20, die die erste Anschlussvorrichtung 12 und die zweite Anschlussvorrichtung 16 elektrisch miteinander verbindet.

Die Widerstandsbaugruppe 20 hat, wie insbesondere in Figur 2 zu sehen ist, einen Messwiderstand 24, ein erstes Anschlusselement 26, das mit der ersten Anschlussvorrichtung 12 verbunden ist, und ein zweites Anschlusselement 28, das mit der zweiten Anschlussvorrichtung 16 verbunden ist. Die erste Anschlussvorrichtung 12 kann auch einstückig mit dem ersten Anschlusselement 26 und/oder die zweite Anschlussvorrichtung 16 einstimmig ist den zweiten Anschlusselement 28 ausgebildet bzw. jeweils aus diesem herausgeformt sein.

Des Weiteren weist der Batteriesensor 10 ein Gehäuse 30 auf, in dem zumindest eine Messeinrichtung zur Erfassung eines Batterieparameters sowie eine Auswerteschaltung zur Auswertung der erfassten Batterieparameter vorgesehen sind.

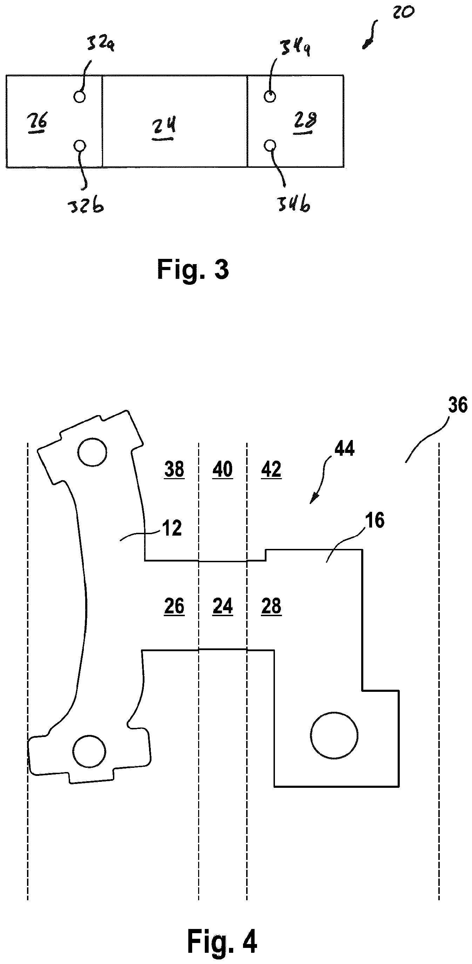

Wie in Figur 3 zu sehen ist, weisen die Anschlusselemente 26, 28 jeweils zwei Kontaktstellen 32a, 32b, 34a, 34b zur Kontaktierung mit einer Messeinrichtung auf. Beispielsweise sind die Kontaktstellen 32a, 32b, 34a, 34b als Kontaktpins oder Kontaktstifte ausgebildet, die einstückig mit den Anschlusselement 26, 28 ausgebildet oder mit diesen verschweißt oder verlötet sind. Vorzugsweise weist die Messeinrichtung eine Spannungserfassungseinrichtung auf, die jeweils mit einer ersten Kontaktstelle 32a, 32b auf dem ersten Anschlusselement und mit einer zweiten Kontaktstelle 34a, 34b auf dem zweiten Anschlusselement 28 kontaktiert ist. Vorzugsweise sind zwei Messeinrichtungen vorgesehen, die jeweils mit einem ersten Kontaktstelle 32a, 32b und einem zweiten Kontaktstelle 34a, 34b elektrisch verbunden sind.

Der Batteriesensor 10 ist im Laststrompfad des Fahrzeugs angeordnet, das heißt, der gesamte Batteriestrom fließt über den Batteriesensor und über den Messwiderstand 24. Aufgrund des elektrischen Widerstandes des Messwiderstandes 24 kommt es entlang des Messwiderstandes bzw. zwischen den Kontaktstellen 32a und 34a beziehungsweise den Kontaktstellen 32b und 34b zu einem Spannungsabfall. Dieser Spannungsabfall kann mit der jeweiligen Spannungserfassungseinrichtung erfasst werden. Ist der elektrische Widerstand zwischen den Kontaktstellen 32a und 34a beziehungswiese 32b und 34b bekannt, kann aus dem erfassten Spannungsabfall und dem bekannten elektrischen Widerstand der über den Batteriesensor fließende Batteriestrom bestimmt werden.

Um eine möglichst genaue Messung des Batteriestroms zu erzielen, wird für den Messwiderstand ein Material mit einer geringen Temperaturabhängigkeit des elektrischen Widerstandes, also einem niedrigen Widerstands-Temperaturkoeffizienten verwendet. Dadurch bleibt der elektrische Widerstand unabhängig von der Temperatur weitgehend konstant. Beispielsweise wird eine Kupfer-Mangan-Nickel-Legierung verwendet.

Für die Anschlusselemente 26, 28 wird üblicherweise weitgehend reines Kupfer verwendet, die einfacher zu verarbeiten ist, insbesondere in einem Stanz-Biege-Prozess, und eine einfache Verbindung mit weiteren Bauteilen ermöglicht, beispielsweise durch Schweißen oder Löten. Weitgehend reines Kupfer weist einen deutlich höheren Widerstands-Temperaturkoeffizienten auf als die Legierung des Messwiderstands. Dadurch wird der Temperaturkoeffizient des Gesamtwiderstands der Messstrecke im Vergleich zum alleinigen Messwiderstand erhöht. Der Widerstands-Temperaturkoeffizient der Gesamtmessstrecke ist bekannt. Er kann beispielsweise mittels einer einmaligen Kalibrierung bestimmt werden. Für die genaue Ermittlung des elektrischen Widerstandes ist zusätzlich eine Temperaturmessung erforderlich, die beispielsweise durch die jeweilige Messeinrichtung erfolgt. Mit einer erfassten Temperatur sowie dem bekannten Widerstands-Temperaturkoeffizient kann der vom Widerstand der Anschlusselemente 26, 28 beeinflusste Gesamtwiderstand der Messstrecke ermittelt werden.

Zusätzlich kann es aber bei Temperaturdifferenzen zwischen den Anschlusselementen 26, 28 und dem Messwiderstand 24 zu Thermospannungen zwischen den Anschlusselement 26, 28 und dem Messwiderstand 24 kommen, die zu einer Verfälschung des erfassten Spannungsabfalls führen können.

Um dies zu vermeiden, wird für die Anschlusselemente 26, 28 ein Material verwendet, das ein deutlich geringeren Widerstands-Temperaturkoeffizienten aufweist als die bisher verwendeten Kupferlegierung. In der hier gezeigten Ausführungsform wird eine Kupfer-Eisen-Phosphor-Legierung verwendet, die einen der Widerstands-Temperaturkoeffizienten von weniger als 3200 ppm/K aufweist. Eine solche Kupfer-Eisen-Phosphor-Legierung weist des Weiteren ähnliche thermoelektrische Eigenschaften auf wie das für das den Messwiderstand 24 verwendete Material, sodass Thermospannung aufgrund von Temperaturunterschieden zwischen den Anschlusselementen 26, 28 und den Messwiderstand reduziert oder vermieden werden können.

Insbesondere kann auch ein Material verwendet werden, das einen niedrigeren Widerstands-Temperaturkoeffizienten aufweist. Das verwendete Material muss aber weiterhin einfach zu verarbeiten sein, beispielsweise durch Biege- und/oder Stanzverfahren. Des Weiteren volles Material einfach mit weiteren Bauteilen des Batteriesensors verwendbar sein, beispielsweise durch Schweißen oder Löten.

Beispielsweise wird die Widerstandsbaugruppe hergestellt, indem ein flächiges Grundmaterial 36 bereitgestellt wird, das aus drei länglichen Abschnitten 38, 40, 42 besteht, wobei ein mittlerer Abschnitt 40 aus dem Material des Messwiderstandes 24 besteht. An den Längskanten des mittleren Abschnitts 40 sind Abschnitt 38, 42 aus dem Material der Anschlusselemente 26, 28 vorgesehen, die beispielsweise mit dem mittleren Abschnitt 40 verschweißt sind. Dieses Grundmaterial kann beispielsweise auf einer Rolle oder als Endlosmaterial angeliefert werden.

Aus diesem Grundmaterial 36 kann ein Grundkörper 44 ausgestanzt werden, der entweder der Form der Widerstandsbaugruppe 20 entspricht, die mit der ersten Anschlussvorrichtung 12 und der zweiten Anschlussvorrichtung 16 verbunden wird. (Siehe Figur 4) Anschließend werden aus dem Grundkörper die erste Anschlussvorrichtung 12 und die zweite Anschlussvorrichtung 16 ausgeformt.

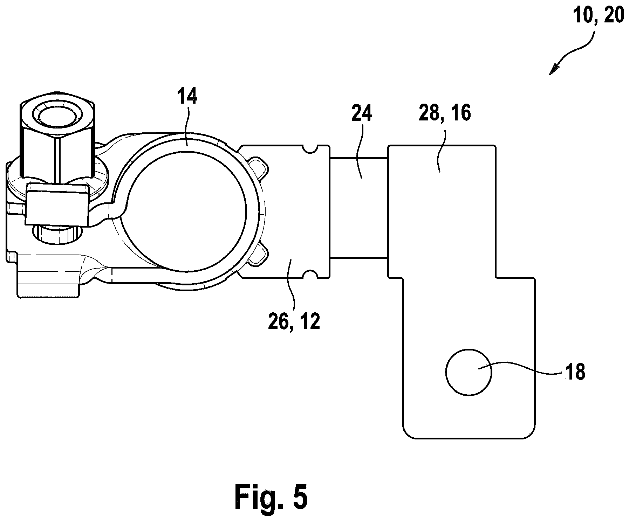

Alternativ kann ein Grundkörper ausgestanzt werden, der jeweils eine Grundform für die erste Anschlussvorrichtung 12 und die zweite Anschlussvorrichtung 16 aufweist. Aus diesen Grundformen werden nachfolgend die erste Anschlussvorrichtung 12 und die zweite Anschlussvorrichtung 16 ausgeformt, beispielsweise durch einen Biege- und/oder einen Stanzprozess (siehe Figur 5). Die erste Anschlussvorrichtung 12, der Messwiderstand 24 und die zweite Anschlussvorrichtung 16 werden anschließend miteinander verschweißt.

### Bezugszeichenliste

- 10: Batteriesensor
- 12: erste Anschlussvorrichtung
- 14: Batteriepolklemme
- 16: zweite Anschlussvorrichtung
- 18: Kabelanschluss
- 20: Widerstandsbaugruppe
- 24: Messwiderstand
- 26: erstes Anschlusselement
- 28: zweites Anschlusselement
- 30: Gehäuse
- 32a, 32b: erste Kontaktstellen
- 34a, 34b: zweite Kontaktstellen
- 36: Grundmaterial
- 38: Abschnitt des Grundmaterials
- 40: mittlerer Abschnitt des Grundmaterials
- 42: Abschnitt des Grundmaterials
- 44: Grundkörper

## Patentansprüche

1. Widerstandsbaugruppe (20) für einen Batteriesensor (10) in einem Fahrzeug, mit einem ersten Anschlusselement (26), einem zweiten Anschlusselement (28) sowie einem Messwiderstand (24) mit einem definierten elektrischen Widerstand, wobei der Messwiderstand (24) zwischen dem ersten Anschlusselement (26) und dem zweiten Anschlusselement (28) angeordnet und elektrisch leitend mit diesen verbunden ist, und wobei der Messwiderstand (24) einen niedrigen Widerstands-Temperaturkoeffizient aufweist, **dadurch gekennzeichnet, dass** das erste Anschlusselement (26) und/oder das zweite Anschlusselement (28) jeweils zumindest in einem an den Messwiderstand (24) angrenzenden Anschlussbereich aus einem Material mit einem geringeren Widerstands-Temperaturkoeffizient als Kupfer, insbesondere eine Kupferlegierung, besteht.

2. Widerstandsbaugruppe nach Anspruch 1, **dadurch gekennzeichnet, dass** das erste Anschlusselement (26) und/oder das zweite Anschlusselement (28) zumindest im Anschlussbereich einen Widerstands-Temperaturkoeffizienten von weniger als 3200 ppm/K, insbesondere von weniger als 2000ppm/K aufweist.

3. Widerstandsbaugruppe nach einem der Ansprüche 1 und 2, **dadurch gekennzeichnet, dass** das erste Anschlusselement (26) und/oder das zweite Anschlusselement (28) zumindest im Anschlussbereich aus einer Kupfer-Eisen-Phosphor Legierung bestehen.

4. Widerstandsbaugruppe nach einem der vorhergehenden Ansprüche, **dadurch gekennzeichnet, dass** das Widerstandselement (24) einen kleineren Temperaturkoeffizienten als das erste Anschlusselement (28) und/oder das zweite Anschlusselement (28) aufweist, insbesondere einen Temperaturkoeffizienten von weniger als 100ppm/K, wobei insbesondere das Widerstandselement (24) aus einer Kupfer-Mangan-Nickel-Legierung besteht.

5. Widerstandsbaugruppe nach einem der vorhergehenden Ansprüche, **dadurch gekennzeichnet, dass** das erste Anschlusselement (26) und/oder das zweite Anschlusselement (28) zumindest im Anschlussbereich die gleiche Dicke aufweisen wie das Widerstandselement, wobei insbesondere die Dicke zwischen 1,5 und 3,5 mm, vorzugsweise zwischen 1,8 und 3 mm beträgt.

6. Widerstandsbaugruppe nach einem der vorhergehenden Ansprüche, **dadurch gekennzeichnet, dass** am ersten Anschlusselement (26) zumindest eine erste Kontaktstelle (32a, 32b) und am zweiten Anschlusselement (28) zumindest eine zweite Kontaktstelle (34a, 34b) vorgesehen ist.

7. Batteriesensor (10) für ein Fahrzeug, mit einer Batteriepolklemme (14) zum Anschließen des Batteriesensors (10) an einer Fahrzeugbatterie, einem Stromanschluss (18) und einer Widerstandsbaugruppe (20) nach einem der vorhergehenden Ansprüche, wobei die Widerstandsbaugruppe (20) die Batteriepolklemme (14) und den Stromanschluss (18) elektrisch leitend miteinander verbindet und wobei eine Messeinrichtung zur Erfassung des über die Widerstandsbaugruppe (20), insbesondere den Messwiderstand (24) fließenden Batteriestrom, vorgesehen ist.

8. Batteriesensor nach Anspruch 7, **dadurch gekennzeichnet, dass** die Messeinrichtung jeweils mit zumindest einer am ersten Anschlusselement (26) vorgesehenen Kontaktstelle (32a, 32b) und mit einer am zweiten Anschlusselement (28) vorgesehenen zweiten Kontaktstelle (34a, 34b) elektrisch leitend verbunden ist.

9. Batteriesensor nach einem der Ansprüche 7 und 8, **dadurch gekennzeichnet, dass** die Messeinrichtung eine Spannungserfassungseinrichtung zur Erfassung eines Spannungsabfalls über das Widerstandselement ist.
